(19) Europäisches Patentamt European Patent Office Office européen des brevets

(11) **EP 4 788 111 A1**

(12) **EUROPEAN PATENT APPLICATION**

(43) Date of publication:
05.08.2026  Bulletin 2026/32

(21) Application number: 26154827.5

(22) Date of filing: 28.01.2026

(51) International Patent Classification (IPC):
*H10P 14/60* (2026.01)       *H10P 14/692* (2026.01)
*H10P 14/694* (2026.01)       *H10P 50/68* (2026.01)
*H10P 95/70* (2026.01)

(52) Cooperative Patent Classification (CPC):
H10P 14/6339; H10P 14/6336; H10P 14/6529;
H10P 14/69215; H10P 14/6922; H10P 14/69433;
H10P 50/683; H10P 95/70; H10P 14/6348

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  31.01.2025  JP 2025015076

(71) Applicant: **Kokusai Electric Corporation
Tokyo 101-0045 (JP)**

(72) Inventor: **NAKATANI, Kimihiko
Toyama-shi, Toyama, 9392393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, PROGRAM, AND SUBSTRATE PROCESSING APPARATUS**

(57)  A technique includes (a) preparing a substrate (200) including a first film formed inside a recess, a surface of the first film inside the recess being terminated with a first termination that reduces wettability with respect to a processing liquid; and (b) removing at least a portion of the first film formed in a first region on an opening side of the recess while leaving the first film formed in a second region on a bottom side of the recess by supplying the processing liquid to the substrate (200) and selectively exposing, to the processing liquid, the surface of the first film formed in the first region with respect to the surface of the first film formed in the second region.

FIG. 7B

## FIG. 7C

(First termination)

First film

H    H

H    H

H    H

200

**Description**

CROSS-REFERENCE TO RELATED APPLICATION

This application is based upon and claims the benefit of priority from Japanese Patent Application No. 2025-015076, filed on January 31, 2025, the entire contents of which are incorporated herein by reference.

TECHNICAL FIELD

The present disclosure relates to a method of processing a substrate, a method of manufacturing a semiconductor device, a program, and a substrate processing apparatus.

BACKGROUND

In the related art, as one of manufacturing processes of semiconductor devices, there is a case where a process of removing (etching) a surface inside a recess formed in a substrate is performed.

SUMMARY

Some embodiments of the present disclosure provide a technique capable of selectively removing a film formed inside a recess by using a processing liquid.
According to embodiments of the present disclosure, there is provided a technique that includes: (a) preparing the substrate including a first film formed inside a recess, a surface of the first film inside the recess being terminated with a first termination that reduces wettability with respect to a processing liquid; and (b) removing at least a portion of the first film formed in a first region on an opening side of the recess while leaving the first film formed in a second region on a bottom side of the recess by supplying the processing liquid to the substrate and selectively exposing, to the processing liquid, the surface of the first film formed in the first region with respect to the surface of the first film formed in the second region.

BRIEF DESCRIPTION OF DRAWINGS

The accompanying drawings, which are incorporated in and constitute a part of the specification, illustrate embodiments of the present disclosure.

FIG. 1 is a schematic configuration diagram of a substrate processing apparatus that is suitably used in each embodiment of the present disclosure.
FIG. 2 is a schematic configuration diagram of a vertical process furnace of a film formation apparatus included in the substrate processing apparatus that is suitably used in each embodiment of the present disclosure, and is a diagram illustrating a portion of the process furnace in a vertical cross-sectional view.
FIG. 3 is a schematic configuration diagram of the vertical process furnace of the film formation apparatus included in the substrate processing apparatus that is suitably used in each embodiment of the present disclosure, and is a diagram illustrating a portion of the process furnace in a cross-sectional view taken along line A-A of FIG. 2.
FIG. 4 is a schematic configuration diagram of a removal apparatus included in the substrate processing apparatus that is suitably used in each embodiment of the present disclosure.
FIG. 5 is a schematic configuration diagram of a controller of the substrate processing apparatus that is suitably used in each embodiment of the present disclosure, and is a diagram illustrating a control system of the controller in a block diagram.
FIG. 6 is a diagram illustrating regions of a recess provided in a surface of a wafer in each embodiment of the present disclosure.

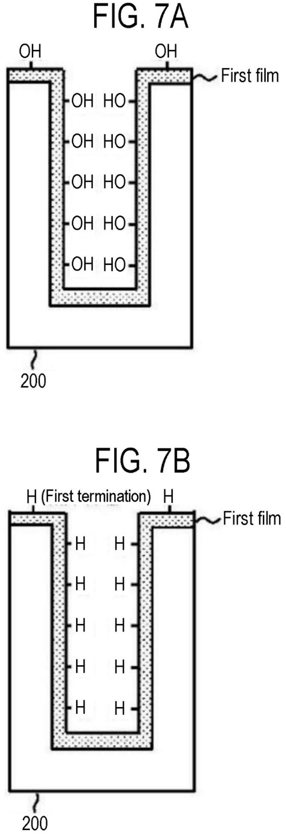

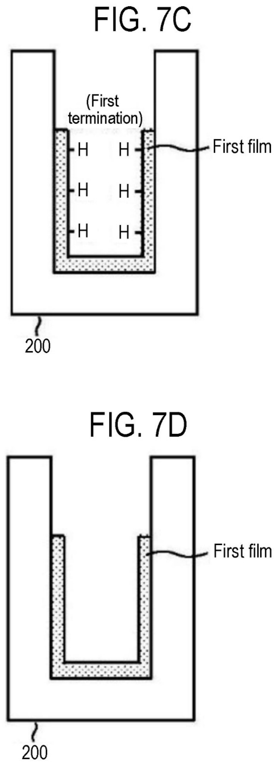

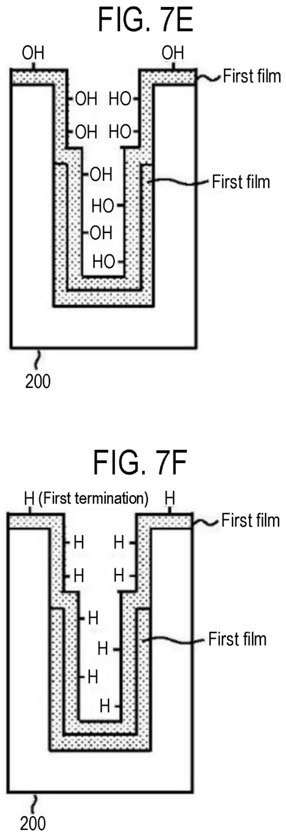

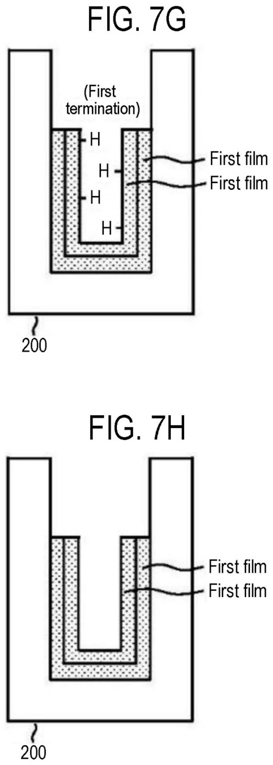

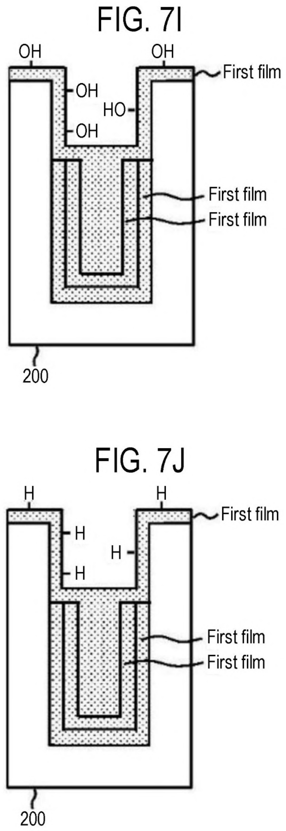

FIGS. 7A to 7J are cross-sectional schematic diagrams of the surface of the wafer including the recess in a first embodiment of the present disclosure. FIG. 7A is a partial schematic diagram of the wafer after forming (first time) a first film. FIG. 7B is a partial schematic diagram of the wafer after forming (first time) a first termination on the first film. FIG. 7C is a partial schematic diagram of the wafer after selectively removing (first time) a portion of the first film. FIG. 7D is a partial schematic diagram of the wafer after removing the first termination from a surface of the first film. FIG. 7E is a partial schematic diagram of the wafer after forming (second time) the first film. FIG. 7F is a partial schematic diagram of the wafer after forming (second time) the first termination on the first film. FIG. 7G is a partial schematic diagram of the wafer after selectively removing (second time) a portion of the first film. FIG. 7H is a partial schematic diagram of the wafer after removing the first termination from a surface of the first film. FIG. 7I is a partial schematic diagram of the wafer after forming (third time) the first film. FIG. 7J is a partial schematic diagram of the wafer after forming (third time) the first termination on the first film.

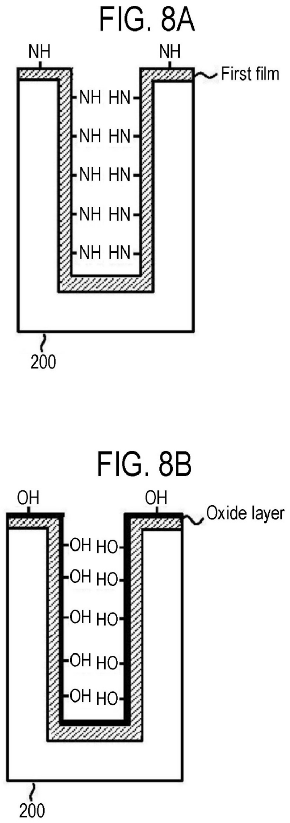

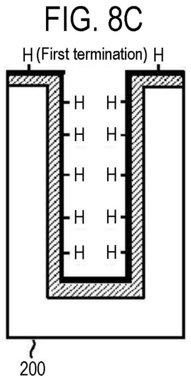

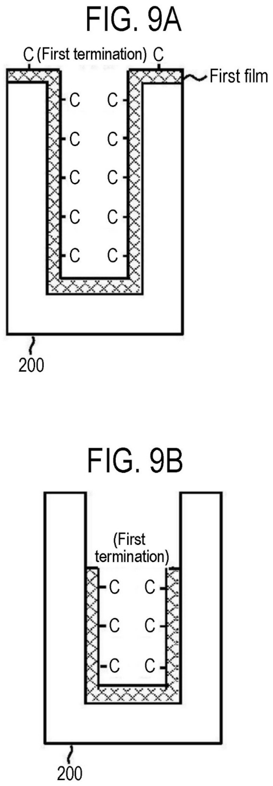

FIGS. 8A to 8C are cross-sectional schematic diagrams of the surface of the wafer including the recess in Modification 1 of the first embodiment of the present disclosure. FIG. 8A is a partial schematic diagram of the wafer after forming (first time) a first film. FIG. 8B is a partial schematic diagram of the wafer after forming an oxide layer on a surface of the first film. FIG. 8C is a partial schematic diagram of the wafer after forming (first time) a first termination on the first film. FIGS. 9A and 9B are cross-sectional schematic diagrams of a surface portion of the wafer including the recess in Modification 2 of the first embodiment of the present disclosure. FIG. 9A is a partial schematic diagram of the wafer after forming (first time) a first film containing a first termination. FIG. 9B is a partial schematic diagram of the wafer after selectively removing (first time) a portion of the first film.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

<First Embodiment of Present Disclosure>

Hereinafter, a first embodiment of the present disclosure is described with reference to the accompanying drawings. In addition, the drawings used in the following description are schematic, and dimensional relationships, proportions, and the like of respective elements illustrated in the drawings may not correspond to those in reality. Further, the dimensional relationships, proportions, and the like of respective elements may not be consistent across multiple drawings.

(1) Configuration of Substrate Processing Apparatus 100

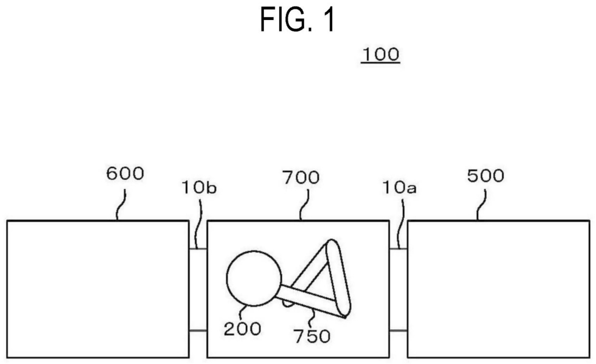

As illustrated in FIG. 1, the substrate processing apparatus 100 mainly includes a film formation apparatus 500, a removal apparatus 600, and a transport chamber 700.

The film formation apparatus 500 is an apparatus that performs film formation process on a wafer 200 during a substrate processing sequence to be described later. The removal apparatus 600 is an apparatus that performs removal (etching) process on the wafer 200 during the substrate processing sequence to be described later. The transport chamber 700 is a region where the wafer 200 is transported between the film formation apparatus 500 and the removal apparatus 600.

(i) Configuration of Film Formation Apparatus 500

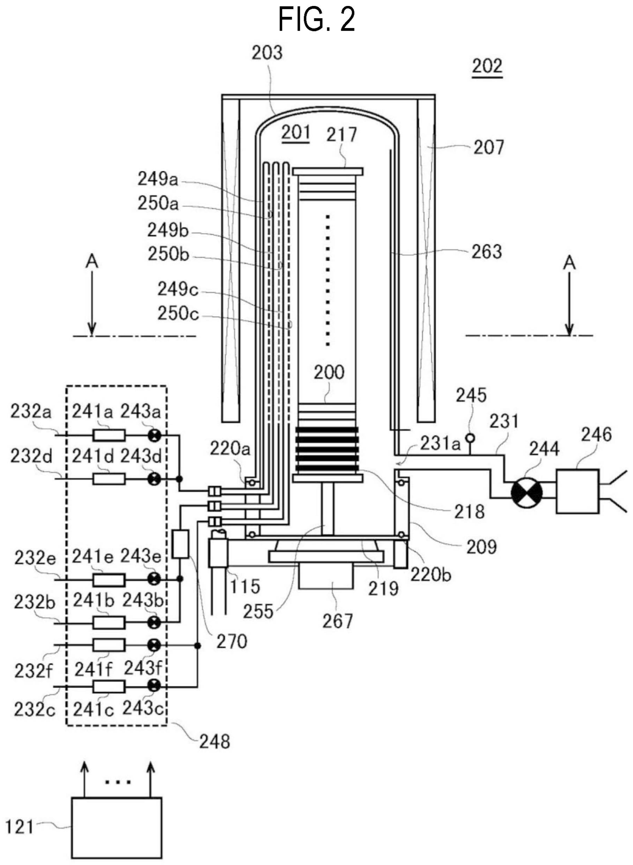

As illustrated in FIG. 2, a process furnace 202 includes a heater 207 that serves as a temperature regulator (heating part). The heater 207 also functions as an activator (exciter) that activates (excites) gases with heat.

A reaction tube 203 is disposed inside the heater 207 to be concentric with the heater 207. The reaction tube 203 is formed in a cylindrical shape with an upper end closed and a lower end opened. A manifold 209 is disposed concentrically with the reaction tube 203 below the reaction tube 203. An O-ring 220a is provided as a seal between the manifold 209 and the reaction tube 203. A process container (reaction container) mainly includes the reaction tube 203 and the manifold 209. A process chamber 201 is formed in a cylindrical hollow region of the process container. The process chamber 201 is configured to be capable of accommodating the wafer 200 serving as a substrate. The wafer 200 is processed inside the process chamber 201.

Nozzles 249a to 249c are installed as first to third suppliers inside the process chamber 201 so as to penetrate a sidewall of the manifold 209, respectively. Gas supply pipes 232a to 232c are connected to the nozzles 249a to 249c, respectively.

In the gas supply pipes 232a to 232c, mass flow controllers (MFCs) 241a to 241c, which serve as flow rate controllers (flow rate control parts), and valves 243a to 243c, which serve as opening/closing valves, are respectively installed in order from an upstream side of a gas flow. A gas supply pipe 232d is connected to the gas supply pipe 232a at a downstream side of the valve 243a. A gas supply pipe 232e is connected to the gas supply pipe 232b at a downstream side of the valve 243b. A gas supply pipe 232f is connected to the gas supply pipe 232c at a downstream side of the valve 243c. In the gas supply pipes 232d to 232f, MFCs 241d to 241f and valves 243d to 243f are respectively installed in order from an upstream side of a gas flow.

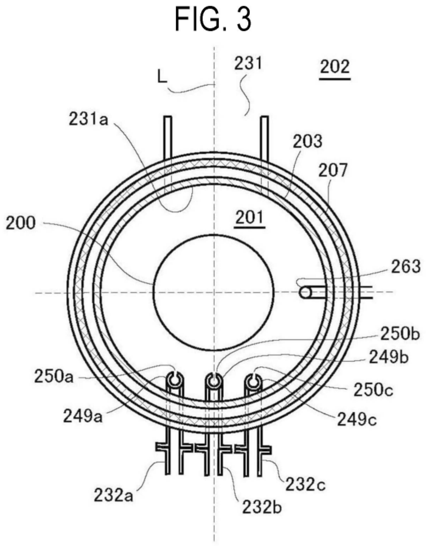

As illustrated in FIG. 3, the nozzles 249a to 249c are each installed in a space between an inner wall of the reaction tube 203 and the wafer 200 so as to extend upward in an arrangement direction of the wafer 200 from a lower portion to an upper portion of the reaction tube 203. Gas supply holes 250a to 250c for supplying gases are formed on side surfaces of the nozzles 249a to 249c, respectively. The gas supply holes 250a to 250c are open so as to oppose (face) an exhaust port 231a in a plane view, enabling supply of gases toward the wafer 200. A plurality of gas supply holes 250a to 250c are formed from the lower portion to the upper portion of the reaction tube 203.

A precursor is supplied from the gas supply pipe 232a into the process chamber 201 through the MFC 241a, valve 243a, and nozzle 249a. The precursor is used as one of film formation agents.

At least one selected from the group of a first reactant and a second reactant is supplied from the gas supply pipe 232b into the process chamber 201 through the MFC 241b, valve 243b, and nozzle 249b. The first reactant and the second reactant are used as one of film formation agents.

At least one selected from the group of a third reactant and a modifying agent is supplied from the gas supply pipe 232c into the process chamber 201 through the MFC 241c, valve 243c, and nozzle 249c. The third reactant is used as one of film formation agents.

An inert gas is supplied from the gas supply pipes 232d to 232f into the process chamber 201 through the MFCs 241d to 241f, valves 243d to 243f, gas supply pipes 232a to 232c, and nozzles 249a to 249c, respectively. The inert gas acts, for example, as a purge gas, a carrier gas, and a dilution gas.

A remote plasma unit (hereinafter, RPU) 270, which is a plasma exciter that excites a substance into a plasma state, is installed downstream of a connector between the gas supply pipe 232b and the gas supply pipe 232e. The RPU 270 is capable of forming a substance into plasma and thus exciting the substance in an interior of the RPU 270 by applying radio frequency (RF) power thereto.

The RPU 270 is configured to be capable of exciting a substance (e.g., the first reactant) supplied from the gas supply pipe 232b into a plasma state and supplying the plasma-excited substance into the process chamber 201.

A precursor supply system mainly includes the gas supply pipe 232a, MFC 241a, and valve 243a. A reactant (first and second reactants) supply system mainly includes the gas supply pipe 232b, MFC 241b, and valve 243b. A reactant (third reactant) supply system or a modifying agent supply system mainly includes the gas supply pipe 232c, MFC 241c, and valve 243c. An inert gas supply system mainly includes the gas supply pipes 232d to 232f, MFCs 241d to 241f, and valves 243d to 243f. Further, the precursor supply system and the reactant supply system are also collectively referred to as a film formation agent supply system. The nozzles connected to the gas supply pipes constituting the above-described various supply systems may be included, respectively, in the corresponding supply systems.

The exhaust port 231a is installed below a sidewall of the reaction tube 203 to exhaust an internal atmosphere of the process chamber 201. An exhaust pipe 231 is connected to the exhaust port 231a. The exhaust pipe 231 is connected to a vacuum pump 246, which serves as a vacuum-exhauster, through a pressure sensor 245, which serves as a pressure detector (pressure detection part) that detects an internal pressure of the process chamber 201, and through an auto pressure controller (APC) valve 244, which serves as a pressure regulator (pressure regulating part). The APC valve 244 is configured to perform or stop vacuum-exhaust inside the process chamber 201 by opening or closing the valve while the vacuum pump 246 is in operation. The APC valve 244 is also configured to regulate the internal pressure of the process chamber 201 by adjusting a valve opening degree based on pressure information detected by the pressure sensor 245 while the vacuum pump 246 is in operation. An exhaust system mainly includes the exhaust pipe 231, APC valve 244, and pressure sensor 245. The vacuum pump 246 may also be included in the exhaust system.

A seal cap 219 is installed below the manifold 209 and serves as a furnace opening lid capable of airtightly closing an opening at a lower end of the manifold 209. An O-ring 220b is installed on an upper surface of the seal cap 219 and serves as a seal that abuts against the lower end of the manifold 209. A rotator 267 that rotates a boat 217 is provided below the seal cap 219. A rotating shaft 255 of the rotator 267 is connected to the boat 217. The rotator 267 is configured to rotate the wafer 200 by rotating the boat 217. A boat elevator 115 is configured as a transport device (transporter) that loads and unloads (transports) the wafer 200 into and out of the process chamber 201 by raising or lowering the seal cap 219.

The boat 217, which serves as a substrate support, is configured to support a plurality of wafers 200, for example, 25 to 200 wafers, in such a state that the wafers 200 are arranged at intervals in a horizontal posture and in multiple stages along a vertical direction with centers of the wafers 200 aligned with one another, i.e., to arrange the wafers 200 at intervals. Heat insulation plates 218 are supported in multiple stages at a lower portion of the boat 217.

A temperature sensor 263 is provided as a temperature detector inside the reaction tube 203. An internal temperature of the process chamber 201 achieves a desired temperature distribution by regulating a state of supplying electric power to the heater 207 based on temperature information detected by the temperature sensor 263.

(ii) Configuration of Removal Apparatus 600

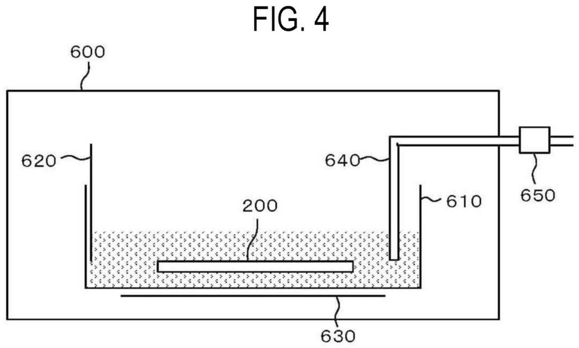

As illustrated in FIG. 4, the removal apparatus 600 includes a process tank 610. The process tank 610 is capable of accommodating one or a plurality of wafers 200. A processing liquid supply pipe 640 is connected to a processing liquid tank (not illustrated) via a liquid mass flow controller (LMFC) 650 and is configured to be capable of supplying a processing liquid into the process tank 610. A processing liquid for exposure is stored inside the process tank 610, and the wafer 200 is immersed in the processing liquid. A processing liquid exposure system (also referred to as a processing liquid supply system for supplying the processing liquid to the wafer 200) that exposes the wafer 200 to the processing liquid includes the processing liquid supply pipe 640 and the LMFC 650. The processing liquid exposure system may further include the process tank 610. Inside the removal apparatus 600, a temperature sensor 620 that detects a temperature of the processing liquid and a heater 630 that regulates the temperature of the processing liquid are included. The temperature sensor 620 is provided along an inner wall of the process tank 610. The heater 630 is disposed near the process tank 610 and is configured to maintain the processing liquid inside the process tank 610 at an appropriate temperature based on the temperature detected by the temperature sensor 620.

(iii) Configuration of Transport Chamber 700

As illustrated in FIG. 1, the transport chamber 700 is configured between the film formation apparatus 500 and the removal apparatus 600 via gate valves 10a and 10b. A transporter 750 that transports the wafer 200 is provided inside the transport chamber 700. The transporter 750 transports the wafer 200 between the film formation apparatus 500 and the removal apparatus 600 by placing the wafer 200 on a substrate mounting table provided on an arm.

(iv) Controller

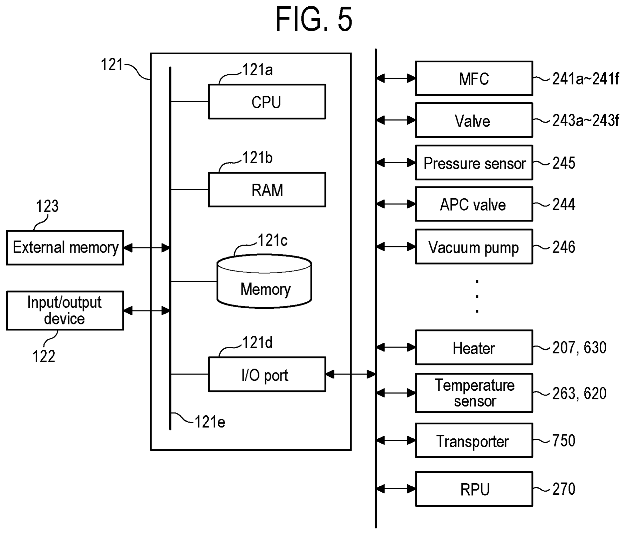

As illustrated in FIG. 5, the controller 121, which serves as a control part (control means) of the film formation apparatus 500, the removal apparatus 600, and the transport chamber 700, is configured as a computer including a central processing unit (CPU) 121a, random access memory (RAM) 121b, memory 121c, and I/O port 121d. The RAM 121b, memory 121c, and I/O port 121d are configured to be capable of exchanging data with the CPU 121a via an internal bus 121e. The controller 121 is connected to an input/output device 122, which is configured as, for example, a touch panel or the like. Further, the controller 121 is made to enable connection to an external memory 123. In addition, the substrate processing apparatus 100 may be configured to include a single controller, or may be configured to include a plurality of controllers. In other words, control for performing a processing sequence to be described later may be performed using a single controller, or may be performed using a plurality of controllers. Further, a plurality of controllers may be configured as a control system by being connected to each other via a wired or wireless communication network, and the control for performing the processing sequence to be described later may be performed by the entire control system. When the term "controller" is used in the present disclosure, it may refer to a case of including a single controller, a case of including a plurality of controllers, or a case of including a control system configured by a plurality of controllers.

The memory 121c is configured with, for example, a flash memory, a hard disk drive (HDD), a solid state drive (SSD), or a similar one. The memory 121c records and stores, in a readable manner, a control program for controlling operations of the substrate processing apparatus 100, a process recipe containing, e.g., substrate processing processes, conditions, and the like to be described later, and others. The process recipe is a combination that causes the controller 121 to execute respective substrate processing processes to be described later in the substrate processing apparatus 100 and obtain predetermined results. Thus, the process recipe functions as a program. Hereinafter, the process recipe, control program, and others are collectively referred to simply as a program (program product). Further, the process recipe is also simply referred to as a recipe. When the term "program" is used in the present disclosure, it may refer to case of solely including the recipe, a case of solely including the control program, or a case of including both. The RAM 121b is configured as a memory area where programs, data, or the like read by the CPU 121a are temporarily held.

The I/O port 121d is connected to the MFCs 241a to 241f, valves 243a to 243f, pressure sensor 245, APC valve 244, vacuum pump 246, gate valves 10a and 10b, temperature sensors 263 and 620, heaters 207 and 630, transporter 750, and others.

The CPU 121a is configured to be capable of reading and executing the control program from the memory 121c, as well as reading the recipe from the memory 121c in response to an operation command input from the input/output device 122. The CPU 121a is configured to be capable of, according to contents of the read recipe, controlling flow rate regulating operations of various substances (various gases) by the MFCs 241a to 241f, opening/closing operations of the valves 243a to 243f, a pressure regulating operation by the APC valve 244 based on an opening/closing operation of the APC valve 244 and the pressure sensor 245, startup and shutdown of the vacuum pump 246, temperature regulating operations of the heaters 207 and 630 based on the temperature sensors 263 and 620, rotation and rotational speed adjusting operation of the boat 217 by the rotator 267, a raising/lowering operation of the boat 217 by the boat elevator 115, an operation of the transporter 750, and others.

The controller 121 may be configured by installing the aforementioned program recorded and stored in the external memory 123 onto a computer. The external memory 123 includes, for example, a magnetic disk such as a HDD, an optical disk such as a CD, a semiconductor memory such as a USB memory or SSD, and others. The memory 121c or the external memory 123 is configured as computer-readable recording medium. Hereinafter, the memory 121c and the external memory 123 may be collectively referred to simply as a recording medium. When the term "recording medium" is used in the present disclosure, it may refer to a case of solely including the memory 121c, a case of solely including the external memory 123, or a case of including both. In addition, the program may be provided to a computer not by using the external memory 123, but via a communication means such as the Internet or a dedicated line.

(2) Substrate Processing Process

A method of processing a substrate using the above-described substrate processing apparatus 100 as one of manufacturing processes of semiconductor devices, i.e., an example of a processing sequence of forming a film on a surface of the wafer 200 serving as a substrate, is described mainly with reference to FIGS. 7A to 7J. In the following description, operations of each part constituting the substrate processing apparatus 100 is controlled by the controller 121.

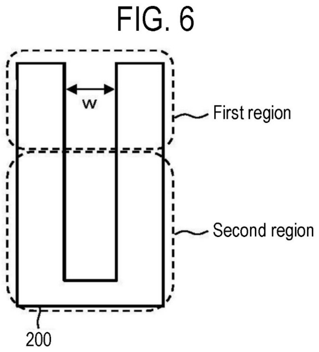

In the present embodiment, an example using the wafer 200 including a recess, which is a three-dimensional structure such as a trench, groove, or hole, formed on a surface of the wafer 200 is described. Further, in the present embodiment, a region on an opening side of the recess and a region on a bottom side of the recess are referred to as a first region and a second region, respectively (see FIG. 6).

In addition, the term "recess" in the present disclosure is not limited to a shape with a bottom surface, and may include, for example, a structure such as a gap or a through-hole that does not include a bottom surface. In a case of a structure not including a bottom surface, the term "bottom side" may refer to a direction (side) toward an interior of the structure when viewed from each of two or more openings.

In the present embodiment, steps A, B, C and D to be described later are mainly performed in this order. Step A is performed in the film formation apparatus 500, step B is performed in the removal apparatus 600, and steps C and D are performed respectively in the film formation apparatus 500.

The meaning of "selectively removing" in the present disclosure is not limited to a case of an embodiment in which removal is performed solely at one side and is not performed at the other side. This meaning also includes a case of an embodiment in which an amount, rate, probability, and others of removal performed on one side is relatively greater than an amount, rate, probability, and others of removal performed on the other side. In other words, this meaning includes a case of an embodiment in which removal is performed preferentially on one side as compared with the other side.

Step A in the present embodiment is

(a) a step of preparing (providing) the wafer 200 in which a first film formed inside a recess is included and a surface of the first film inside the recess is terminated by a first termination that reduces wettability with respect to a processing liquid (see FIG. 7B).

Further, in the present embodiment, a case is described in which: in step A,

(a-1) step a1 of forming the first film containing a predetermined element inside the recess by supplying a precursor containing the predetermined element to the wafer 200 is performed (see FIG. 7A); and
(a-2) step a2 of modifying the surface of the first film into a surface containing the first termination by supplying a modifying agent to the wafer 200 on which the first film is formed inside the recess is performed (see FIG. 7B).

Further, in the present embodiment, a case is described in which, in step a1, the first film is formed inside the recess by performing, a predetermined number of times ($m_1$ times, where $m_1$ is an integer of 1 or 2 or more), a cycle including:

step a1a of supplying the precursor to the wafer 200; and
step a1b of supplying a first reactant to the wafer 200.

Further, in the present embodiment, a case is described in which the recess is filled with the first film by performing, a predetermined number of times ($n_1$ times, where $n_1$ is an integer of 1 or 2 or more), a cycle including:

(b) after step A, step B of removing at least a portion of the first film formed in a first region on an opening side of the recess while leaving the first film formed in a second region on a bottom side of the recess by supplying the processing liquid to the wafer 200 and selectively exposing, to the processing liquid, the surface of the first film formed in the first region with respect to the surface of the first film formed in the second region (see FIG. 7C);
(c) after step B, step C of forming the first film inside the recess, from which the first film formed in the first region is removed, by supplying the precursor to the wafer 200 (see FIG. 7E); and
(d) after step C, step D of modifying the surface of the first film into a surface containing the first termination by supplying a modifying agent to the wafer 200 on which the first film is formed inside the recess (see FIG. 7F).

Further, in the present embodiment, a case is described in which, in step C, the first film is formed inside the recess by performing, a predetermined number of times ($m_2$ times, where $m_2$ is an integer of 1 or 2 or more), a cycle including:

step c1 of supplying the precursor to the wafer 200; and
step c2 of supplying the first reactant to the wafer 200.

Further, in the present embodiment, a case is described in which:
(e) after step B, step E of performing heat treatment (annealing) on the wafer 200 to remove at least a portion of the first termination from the surface of the first film is performed (see FIG. 7D).

In the present disclosure, for convenience, the above-described processing sequence may also be represented as follows. The same notation is also used in the following description of modifications and other embodiments.

$$\text{(Precursor} \rightarrow \text{first reactant)} \times m_1 \rightarrow \text{modifying agent} \rightarrow [\text{processing liquid} \rightarrow \text{heat treatment} \rightarrow \text{(precursor} \rightarrow \text{first reactant)} \times m_2 \rightarrow \text{modifying agent}] \times n_1$$

The term "wafer" as used in the present disclosure may refer to a wafer itself, or may refer to a stack including the wafer and a predetermined layer or film formed on a surface of the wafer. The term "surface of a wafer" used in the present disclosure may refer to a surface of a wafer itself, or a surface of a predetermined layer or the like formed on a wafer. When it is stated in the present disclosure that "a predetermined layer is formed on a wafer," it may refer to a case where a predetermined layer is directly formed on a surface of a wafer itself, or a case where a predetermined layer is formed on a layer or the like formed on a wafer. The term "substrate" used in the present disclosure is synonymous with the term "wafer."

The term "agent" used in the present disclosure includes at least one selected from the group of a gaseous substance and a liquid substance. The liquid substance includes a mist-like substance. That is, each of the film formation agents (precursor and reactant) and the modifying agent may contain a gaseous substance, may contain a liquid substance such as mist-like substance, or may contain both.

The term "layer" used in the present disclosure includes at least one selected from the group of a continuous layer and a discontinuous layer. For example, first to sixth layers and oxide layers may each include a continuous layer, may each include a discontinuous layer, or may include both.

In the present disclosure, when describing adsorption or reaction of the precursor, reactant, and modifying agent with respect to the surface of the wafer 200, the description may include embodiments in which they adsorb on or react with the surface of the wafer in an undecomposed state, as well as embodiments in which intermediates generated by decomposition thereof or separation of ligands thereof adsorbs on or reacts with the surface of the wafer 200.

(Wafer Charge and Boat Loading)

When a plurality of wafers 200 are charged into the boat 217 by the transporter 750, the boat 217 supporting the plurality of wafers 200 is loaded into the process chamber 201 (boat loading) by the boat elevator 115, as illustrated in FIG. 2.

(Pressure Regulation and Temperature Regulation)

After the boat loading is completed, an interior of the process chamber 201, i.e., a space in which the wafers 200 are present, is vacuum-exhausted (decompression-exhausted) by the vacuum pump 246 to reach a desired pressure (degree of vacuum). Further, the wafers 200 inside the process chamber 201 are heated by the heater 207 so as to reach a desired processing temperature. Further, the rotation of the wafers 200 is initiated by the rotator 267. Further, the heater 630 is controlled based on temperature information detected by the temperature sensor 620 so that the processing liquid inside the process tank 610 reaches a desired temperature. The exhaust of the interior of the process chamber 201, the heating and rotation of the wafers 200, and the temperature regulation of the processing liquid are continuously performed at least until the wafers 200 are completely processed.

Thereafter, the following steps A, B, E, C and D are sequentially executed. In addition, in step A, the following steps a1 and a2 are sequentially executed.

[Step A: Preparation Process]

(Step a1: Film Formation Process)

In this step, a precursor containing a predetermined element and a first reactant are supplied to the wafer 200.

Thus, a first film containing the predetermined element is formed inside the recess. In this step, specifically, the following steps a1a and a1b are sequentially executed.

[Step a1a]

In this step, the precursor containing the predetermined element is supplied to the wafer 200 inside the process chamber 201. Specifically, the valve 243a is opened, and the precursor is flowed into the gas supply pipe 232a. The precursor is regulated in flow rate by the MFC 241a, is supplied into the process chamber 201 through the nozzle 249a, and is exhausted from the exhaust port 231a. At this time, the precursor is supplied to the wafer 200. At this time, the valves 243d to 243f may be opened so that an inert gas is supplied into the process chamber 201 through the respective nozzles 249a to 249c. In addition, the precursor used in this step may be particularly referred to as the first precursor, and the precursor supply system that supplies the first precursor to the wafer 200 may be particularly referred to as a first precursor supply system.

A processing condition when supplying the precursor in this step is exemplified as follows:

Processing temperature (first temperature): room temperature to 600 degrees C, desirably 50 to 400 degrees C;
Processing pressure: 1 to 101,325 Pa, desirably 1 to 1,300 Pa;
Precursor supply flow rate: 0.001 to 2 slm, desirably 0.001 to 1 slm;
Precursor supply time: 1 second to 240 minutes, desirably 30 seconds to 120 minutes; and
Inert gas supply flow rate (for each gas supply pipe): 0 to 20 slm.

In addition, the notation of numerical ranges such as "50 to 400 degrees C" in the present disclosure refers that the lower and upper limits are included in that range. Therefore, for example, "50 to 400 degrees C" refers to "50 degrees C or higher and 400 degrees C or lower." The same applies to other numerical ranges. Further, in the present disclosure, the processing temperature refers to a temperature of the wafer 200 or the internal temperature of the process chamber 201, and the processing pressure refers to the internal pressure of the process chamber 201, i.e., a pressure of the space in which the wafer 200 is present. Further, a processing time refers to a time during which that processing is continued. Further, when a supply flow rate includes 0 slm, 0 slm refers to a case where that no substance is supplied. These similarly apply to the following description.

By supplying the precursor to the wafer 200 under the above-described processing condition, at least a portion of a molecular structure of molecules constituting the precursor may be adsorbed onto the first region and the second region, thereby forming a first layer on these regions.

As the precursor, for example, a Si-containing substance that contains silicon (Si), which is the predetermined element, i.e., a main component of the first film formed in step a1, may be used. As the Si-containing substance, for example, a substance containing halogen and Si, i.e., a halosilane, may be used. Examples of the halogen may include chlorine (Cl), fluorine (F), bromine (Br), iodine (I), and the like. Examples of the halosilane may include a chlorosilane, fluorosilane, bromosilane, iodosilane, and the like.

As the precursor, for example, a chlorosilane such as monochlorosilane ($SiH_3Cl$), dichlorosilane ($SiH_2Cl_2$), trichlorosilane ($SiHCl_3$), tetrachlorosilane ($SiCl_4$), hexachlorodisilane ($Si_2Cl_6$), octachlorotrisilane ($Si_3Cl_8$), or the like may be used.

As the precursor, for example, a substance containing an amino group and Si, i.e., an aminosilane, may also be used.

As the precursor, for example, an aminosilane such as tetrakis(dimethylamino)silane ($Si[N(CH_3)_2]_4$), tris(di-methylamino)silane, bis(diethylamino)silane ($Si[N(C_2H_5)_2]_2H_2$), bis(tert-butylamino)silane ($SiH_2[NH(C_4H_9)]_2$), (diisopro-pylamino)silane ($SiH_3[N(C_3H_7)_2]$), or the like may be used.

One or more of these may be used as the precursor.

As the inert gas, a nitrogen (N2) gas or a noble gas such as argon (Ar) gas, helium (He) gas, neon (Ne) gas, xenon (Xe) gas, or the like may be used. One or more of these may be used as the inert gas. This also applies to each step to be described later.

After forming the first layer on the first region and the second region of the wafer 200, the valve 243a is closed to stop the supply of the precursor into the process chamber 201.

Then, the interior of the process chamber 201 is vacuum-exhausted, so that gaseous substances and others remaining inside the process chamber 201 are removed. At this time, the valves 243d to 243f are opened so that an inert gas is supplied into the process chamber 201 through the nozzles 249a to 249c. The inert gas acts as a purge gas, thereby purging the space in which the wafers 200 are present, i.e., the interior of the process chamber 201.

[Step a1b]

After step a1a is completed, the first reactant is supplied to the wafer 200 inside the process chamber 201, i.e., to the wafer 200 on which the first layer is formed on the first region and the second region.

Specifically, the valve 243b is opened, and the first reactant is flowed into the gas supply pipe 232b. The first reactant is regulated in flow rate by the MFC 241b, is supplied into the process chamber 201 through the nozzle 249b, and is exhausted from the exhaust port 231a. At this time, the first reactant is supplied to the wafer 200.

A processing condition when supplying the first reactant in this step is exemplified as follows:

First reactant supply flow rate: 0.001 to 20 slm, desirably 0.001 to 10 slm; and
First reactant supply time: 1 second to 240 minutes, desirably 30 seconds to 120 minutes.

The other processing condition may be the same as the processing condition when supplying the precursor in step ala.

By supplying the first reactant to the wafer 200 under the above-described processing condition, at least a portion of the first layer formed on the first region and the second region may be modified. For example, in a case where an oxygen (O)-containing substance is used as the first reactant, the first layer on the first region and the second region is oxidized, resulting in formation of a second layer containing an OH-group (hydroxyl-group) termination (OH termination).

As the first reactant, for example, the above-described O-containing substance may be used. Examples of the O-containing substance may include oxygen $(O_2)$, ozone $(O_3)$, nitrous oxide $(N_2O)$, nitric oxide (NO), nitrogen dioxide $(NO_2)$, carbon monoxide (CO), carbon dioxide $(CO_2)$, and the like. One or more of these may be used as the first reactant.

Further, for example, an O- and H-containing substance may be used as the first reactant. Examples of the O- and H-containing substance may include water vapor $(H_2O)$, hydrogen peroxide $(H_2O_2)$, a mixture of $H_2$ and $O_2$, a mixture of $H_2$ and $O_3$, and the like. In other words, a mixture of an O-containing substance and an H-containing substance may also be used as the O- and H-containing substance. In this case, a deuterium (D)-containing substance may also be used instead of the H-containing substance. Deuterium $(D_2)$ may be used as the D-containing substance. One or more of these may be used as the first reactant.

After the first layer formed on the first region and the second region of the wafer 200 is changed into the second layer, the valve 243b is closed to stop the supply of the first reactant into the process chamber 201. Then, gaseous substances and others remaining inside the process chamber 201 are removed from the interior of the process chamber 201 according to the same processing procedure and processing condition as those of purging in step ala.

[Execution for Predetermined Number of Times]

By performing a cycle in which the above-described steps a1a and alb are performed in this order non-simultaneously (i.e., alternately or intermittently) $m_1$ times (where, $m_1$ is an integer of 1 or 2 or more), the first film may be formed in the first region and the second region of the wafer 200. The first film formed inside the recess of the wafer 200 may define an inner space of the recess that is in fluid communication with an outer space of the recess. For example, in a case where the above-described precursor and first reactant are used, the first film such as an SiO film may be formed in the first region and the second region. In this way, for example, the first film that includes a surface formed with an OH termination is formed in the first region and the second region (*see* FIG. 7A). The OH termination formed on the surface of the first film acts as an adsorption site for a modifying agent supplied in step a2 to be described later. That is, the first film containing the OH termination acts as an adsorption promoting film for the modifying agent. It is desirable that the above-described cycle be repeated multiple times until a film thickness of the first film formed by stacking the second layer becomes a desired film thickness.

(Step a2: Modification Process)

After step alb is completed, a modifying agent is supplied to the wafer 200 inside the process chamber 201, i.e., to the wafer 200 on which the first film is formed in the first region and the second region. Specifically, the valve 243c is opened, and for example, a gaseous modifying agent is flowed into the gas supply pipe 232c. The modifying agent is regulated in flow rate by the MFC 241c, is supplied into the process chamber 201 through the nozzle 249c, and is exhausted from the exhaust port 231a. At this time, the modifying agent is supplied to the wafer 200. At this time, the valves 243d to 243f may be opened so that an inert gas is supplied into the process chamber 201 through the respective nozzles 249a to 249c. In addition, the modifying agent used in this step may be particularly referred to as a first modifying agent, and the modifying agent supply system that supplies the first modifying agent to the wafer 200 may be particularly referred to as a first modifying agent supply system.

A processing condition when supplying the modifying agent in this step is exemplified as follows:

Processing temperature: 25 to 500 degrees C, desirably 50 to 300 degrees C;
Processing pressure: 1 to 13,300 Pa, desirably 50 to 1,330 Pa;
Modifying agent supply flow rate: 0.01 to 3 slm, desirably 0.5 to 1 s1m; and
Modifying agent supply time: 0.1 second to 120 minutes, desirably 30 seconds to 60 minutes.

The other processing condition may be similar to that used when supplying the precursor in step ala.

By supplying the modifying agent to the wafer 200 under the above-described processing condition, a third layer may be formed by adsorbing, on the surface of the first film, at least a portion of a molecular structure of molecules constituting the modifying agent. Specifically, the OH termination formed on the surface of the first film may react with the modifying agent so that at least a portion of the molecular structure of the molecules constituting the modifying agent may be adsorbed on the surface of the first film. Thus, it becomes possible to terminate the surface of the first film with at least a portion of the molecular structure of the molecules constituting the modifying agent. As at least a portion of the molecular structure of the molecules constituting the modifying agent, for example, a residue (e.g., Si-H) containing a bond between a hydrogen group (H group) and an atom (e.g., Si) adsorbed on the surface of the first film, which remains after a functional group (e.g., an amino group) of the molecules constituting the modifying agent reacts with the OH termination and is desorbed, or a residue (e.g., Si-OR) containing a bond between an alkoxy group and an atom adsorbed on the surface of the first film, which remains after the functional group of the molecules constituting the modifying agent reacts with the OH termination and is desorbed, may be exemplified. When terminated with such a residue, the first termination such as a H termination or an alkoxy group termination is formed on the surface of the first film (see FIG. 7B, which illustrates an example of forming a H termination as the first termination). Examples of the alkoxy group termination include a methoxy group termination, ethoxy group termination, propoxy group termination, butoxy group termination, and the like. The first termination formed on the surface of the first film is a termination that reduces wettability of an outermost surface of the wafer 200. By forming the first termination on the surface of the first film, the wettability of the wafer 200 with respect to the processing liquid may be reduced in step B to be described later.

As the modifying agent, for example, a compound containing Si as a predetermined element such as tris(dimethylamino)silane $(Si[N(CH_3)_2]_3H)$, bis(diethylamino)silane $(Si[N(C_2H_5)_2]_2H_2)$, bis(tert-butylamino)silane $(SiH_2[NH(C_4H_9)]_2)$, (diisopropylamino)silane $(SiH_3[N(C_3H_7)_2])$, (diisobutylamino)silane $(SiH_3[N(C_4H_9)_2])$, (diisopentylamino)silane $(SiH_3[N(C_5H_{11})_2])$, or the like may be used. More specifically, a substance in which Si is bonded to hydrogen (H) and an amino group, i.e., an aminosilane, may be used. In particular, it is desirable to use a substance in which Si is bonded to three H atoms and one amino group such as a (diisobutylamino)silane, (diisopropylamino)silane, or the like, i.e., a monoaminosilane. By using a monoaminosilane as the modifying agent, a more uniform and sufficient first termination (H termination) may be formed on the surface of the first film in this step.

Further, as the modifying agent, for example, a compound containing Si as a predetermined element such as (dimethylamino)trimethoxysilane $(Si(OCH_3)_3[N(CH_3)_2])$, (dimethylamino)triethoxysilane $(Si(OC_2H_5)_3[N(CH_3)_2])$, (dimethylamino)tripropoxysilane $(Si(OC_3H_7)_3[N(CH_3)_2])$, (dimethylamino)tributoxysilane $(Si(OC_4H_9)_3[N(CH_3)_2])$, or the like may be used. More specifically, a substance in which Si is bonded to an alkoxy group and an amino group may be used. In particular, it is desirable to use a substance in which Si is bonded to three alkoxy groups and one amino group. By using such a substance as the modifying agent, a more uniform and sufficient first termination (alkoxy group termination) may be formed on the surface of the first film in this step.

One or more of these may be used as the modifying agent.

(After-Purge and Atmospheric Pressure Recovery)

After forming the first termination in the first region and the second region of the wafer 200, the valve 243c is closed to stop the supply of the modifying agent into the process chamber 201. Then, gaseous substances and others remaining inside the process chamber 201 are removed from the interior of the process chamber 201 according to the same processing procedure and processing condition as those of purging in step ala. Thereafter, the internal atmosphere of the process chamber 201 is replaced with an inert gas, and the internal pressure of the process chamber 201 is returned to atmospheric pressure.

(Boat Unloading and Wafer Discharge)

Thereafter, the seal cap 219 is lowered by the boat elevator 115 to open the lower end of the manifold 209. Then, the wafer 200 is unloaded from the lower end of the manifold 209 to an outside of the reaction tube 203 while being supported by the boat 217. After being unloaded to the outside of the reaction tube 203, the wafer 200 is taken out from the boat 217 by the transporter 750.

The wafer 200 taken out from the boat 217 is placed on a mounting stage (not illustrated) installed inside the removal apparatus 600 by way of the transport chamber 700 by the transporter 750.

[Step B: Removal (Etching) Process]

In this step, a processing liquid is supplied to the wafer 200 inside the removal apparatus 600, i.e., to the wafer 200 on which the first termination is formed on the surface of the first film. Specifically, the wafer 200 is exposed to the processing liquid, which is supplied through the processing liquid supply pipe 640 and is stored in the process tank 610. More specifically, the wafer 200 placed on the mounting stage inside the removal apparatus 600 is immersed in the processing liquid stored inside the process tank 610 by a transferrer (not illustrated) installed inside the removal apparatus 600.

A processing condition when supplying the processing liquid (i.e. exposing to the processing liquid) in this step is exemplified as follows:

Exposure temperature: 0 to 100 degrees C, desirably 15 to 50 degrees C; and
Exposure time: 0.1 second to 120 minutes, desirably 0.5 second to 60 minutes.

In addition, the processing condition in this step may be changed from cycle to cycle as bottom-up film formation proceeds, as described later.

In addition, the exposure temperature in the present disclosure refers to the temperature of the wafer 200 in the processing liquid or the temperature of the processing liquid. The exposure time refers to a time during which exposure is continued, specifically, a supply time of the processing liquid. These similarly apply to the following description.

By supplying the processing liquid to the wafer 200 under the above-described processing condition, the surface of the first film formed in the first region may be selectively exposed to the processing liquid with respect to the surface of the first film formed in the second region. In other words, at least a portion of the first film facing the inner space of the recess, specifically, the first film formed in the second region among the first film formed in the first region and the second region, may be prevented from being exposed to the processing liquid. Thus, at least a portion of the first film facing the inner space of the recess, specifically, the first film formed in the second region may not be removed. That is, at least a portion of the first film formed in the first region may be removed, with the first film formed in the second region left remaining (see FIG. 7C).

As described above, the first termination formed on the surface of the first film is a termination that reduces the wettability of the outermost surface of the wafer 200. In a case where the processing liquid is an aqueous solution, the first termination is a termination that imparts hydrophobicity (water repellency) to the outermost surface of the wafer 200. A contact angle of the first film containing the first termination on the surface thereof with respect to the processing liquid is desirably 70 to 95 degrees. Further, a desirable degree of wettability of the first film containing the first termination on the surface thereof is such that, at an execution start time of this step, the processing liquid is unable to penetrate an interior of the recess (that is, this refers that the processing liquid is substantially unable to come into contact with a sidewall inside the recess, and includes a state where a portion of the processing liquid protrudes into the recess without coming into contact with the sidewall). In this case, at the execution start time of this step, the processing liquid reaches (comes into contact with) the first film near an opening of the recess, and the first film near the opening is removed. In addition, the expression "unable to penetrate" in the present disclosure refers that the processing liquid is substantially unable to come into contact with an inner sidewall surface of the recess, and includes a state where a portion of the processing liquid protrudes into the recess without coming into contact with the sidewall.

Further, as this step proceeds, the first film is removed from the opening side over time. Accordingly, since an opening width of the recess increases as the first termination is removed from the opening side in sequence together with the first film, a region where the processing liquid is able to penetrate expands from the opening side toward the bottom side of the recess. Then, in the present embodiment, exposure to the processing liquid is continued until the processing liquid reaches (penetrates) the entire first region (the opening side of the recess) and at least a portion of the first film formed in the first region is removed, and the exposure to the processing liquid is stopped before the processing liquid reaches the second region (the bottom side of the recess). Therefore, the first film formed in the first region may be selectively removed with respect to the first film formed in the second region (see FIG. 7C).

In this step, it is desirable to control a range of the surface of the first film exposed to the processing liquid by regulating the supply time (exposure time) of the processing liquid to the wafer 200. For example, when exposing the first film near the opening among the first film formed in the first region to the processing liquid, it is desirable to shorten the supply time of the processing liquid. On the other hand, when exposing even the first film near the second region to the processing liquid, it is desirable to lengthen the supply time of the processing liquid. Further, although FIG. 7C illustrates an example in which the supply (exposure) of the processing liquid in this step is continued until the surface of the wafer 200 in the entire first region is exposed, the supply of the processing liquid in this step may be stopped before the surface of the wafer 200 in the entire first region is exposed, or before at least a portion of the surface of the wafer 200 in the first region is exposed. In this step, at least a portion of the first film formed in the first region is removed such that the opening width of the recess is increased.

A hydrofluoric acid (HF) aqueous solution may be used as the processing liquid. By using an aqueous solution such as a HF aqueous solution or the like as the processing liquid, an OH termination may be formed on the surface inside the recess that is brought into contact with the processing liquid, and a density of the OH termination may be regulated (e.g., increased).

After selectively removing the first film formed in the first region, the wafer 200 is lifted from the process tank 610 by the transferrer and is placed on the mounting stage inside the removal apparatus 600. The wafer 200 placed on the mounting stage is unloaded out of the removal apparatus 600 by the transporter 750, and is charged onto the boat 217 by way of the transport chamber 700.

(Wafer Charge and Boat Loading)

Thereafter, the wafer 200 is charged onto the boat 217 and is loaded into the process chamber 201 through the same procedure as the above-described wafer charge and boat loading.

(Pressure Regulation and Temperature Regulation)

Thereafter, the internal pressure and internal temperature of the process chamber 201 are regulated through the same procedure as the above-described pressure regulation and temperature regulation. At this time, in preparation for step E to be described later, an output of the heater 207 is regulated to raise the internal temperature of the process chamber 201 from the first temperature to a second temperature higher than the first temperature.

[Step E: Heat Treatment (Annealing) Process]

When the internal temperature of the process chamber 201 is stabilized at the second temperature, a heat treatment (annealing) is performed on the wafer 200 that is loaded into the process chamber 201 of the film formation apparatus 500 from the removal apparatus 600, i.e., the wafer 200 from which the first film formed in the first region is selectively removed.

A processing condition when performing the heat treatment in this step is exemplified as follows:

Processing temperature (second temperature): 400 to 700 degrees C, desirably 450 to 600 degrees C;
Processing pressure: 500 to 101,325 Pa, desirably 800 to 10,133 Pa; and
Processing time: 30 to 120 minutes, desirably 30 to 60 minutes.

By performing the heat treatment on the wafer 200 under the above-described processing condition, the first termination that terminates the surface of the first film remaining in the second region may be removed (desorbed) *(see* FIG. 7D). In this way, in this step, the first termination, which acts as an inhibitor that inhibits adsorption of the precursor onto the surface of the wafer 200 in step B to be described later, may be desorbed, thereby bringing the surface of the wafer 200 into a state where the precursor readily adsorbs.

Thereafter, the output of the heater 207 is regulated to lower the processing temperature from the second temperature to the first temperature. At this time, purging inside the process chamber 201 is performed through the same processing procedure and processing condition as those in step a1a.

[Step C: Film Formation Process]

In this step, a precursor containing a predetermined element and a first reactant are supplied to the wafer 200 inside the process chamber 201. Thus, the first film is formed inside the recess from which the first film formed in the first region is removed, and more specifically, on a surface inside the recess from which the first film formed in the first region is removed. In this step, specifically, the following steps c1 and c2 are sequentially executed. In addition, the expression "surface inside the recess from which the first film is removed" in this step is not limited to the surface of the wafer 200 exposed by the removal of the first film in step B, but may include, for example, in the present embodiment, the surface of the first film remaining in the second region, as in the example illustrated in FIG. 7D.

[Step c1]

After the internal temperature of the process chamber 201 is lowered to the first temperature and is stabilized, the precursor is supplied to the wafer 200. In this step, the precursor may be supplied to the wafer 200 according to the same processing procedure and processing condition as the precursor supply in step a1a. The precursor used in this step may be referred to particularly as a second precursor.

By supplying the precursor to the wafer 200 under the above-described processing condition, at least a portion of

13

a molecular structure of molecules constituting the precursor may be adsorbed on the surface inside the recess from which the first film formed in the first region is removed, and a fourth layer may be formed on the first region and the second region.

Further, as the precursor (second precursor) supplied to the wafer 200 in this step, a gas containing one or more of the gases exemplified as the precursor (first precursor) supplied to the wafer 200 in step a1a may be used. The second precursor may be the same as or different from the first precursor. In a case where a precursor different from the first precursor is used as the second precursor, a second precursor supply system configured to supply the second precursor is further installed. The second precursor supply system is configured, similarly to the above-described precursor supply system, with, for example, a gas supply pipe connected to the nozzle 249a, an MFC, and a valve.

After forming the fourth layer on the first region and the second region of the wafer 200, the valve 243a is closed to stop the supply of the precursor into the process chamber 201.

Then, gaseous substances and others remaining inside the process chamber 201 are removed from the interior of the process chamber 201 according to the same processing procedure and processing condition as those of purging in step a1a.

[Step c2]

After step c1 is completed, the first reactant is supplied to the wafer 200 inside the process chamber 201, i.e., to the wafer 200 on which the fourth layer is formed in the first region and the second region. In this step, the first reactant may be supplied to the wafer 200 according to the same processing procedure and processing condition as the first reactant supply in step a1b. The reactant used in this step may be referred to particularly as a fourth reactant.

By supplying the first reactant to the wafer 200 under the above-described processing condition, at least a portion of the fourth layer formed on the first region and the second region in step c1 may be modified. For example, in a case where an O-containing substance is used as the first reactant, the fourth layer on the first region and the second region is oxidized, and a fifth layer containing an OH-group termination (OH termination) is formed.

Further, as the first reactant (fourth reactant) supplied to the wafer 200 in this step, a gas containing one or more of the gases exemplified as the first reactant supplied to the wafer 200 in step a1b may be used. The fourth reactant may be the same as or different from the first reactant. In a case where a reactant different from the first reactant is used as the fourth reactant, a fourth reactant supply system configured to supply the fourth reactant is further installed. The fourth reactant supply system is configured, similarly to the above-described first reactant supply system, with, for example, a gas supply pipe connected to the nozzle 249b, an MFC, and a valve.

After the fourth layer formed on the first region and the second region of the wafer 200 is changed into the fifth layer, the valve 243b is closed to stop the supply of the first reactant into the process chamber 201. Then, gaseous substances and others remaining inside the process chamber 201 are removed from the interior of the process chamber 201 according to the same processing procedure and processing condition as those of purging in step a1a.

[Execution for Predetermined Number of Times]

By performing a cycle in which the above-described steps c1 and c2 are performed in this order non-simultaneously $m_2$ times (where, $m_2$ is an integer of 1 or 2 or more), a new first film may be formed on the surface inside the recess from which the first film formed in the first region is removed. Specifically, in the first region, a new first film may be formed on the wafer 200 after the previous first film is removed in step B, and in the second region, a new first film may be formed on the previous first film remaining without being removed in step B (*see* FIG. 7E). In a case where the above-described precursor and first reactant are used, the first film such as an SiO film may be formed in the first region and the second region. In this way, for example, the first film including a surface formed with an OH termination may be formed in the first region and the second region (*see* FIG. 7E). It is desirable that the above-described cycle be repeated multiple times until a film thickness of the first film formed by stacking the fifth layer becomes a desired film thickness.

[Step D: Modification Process]

After step C is completed, a modifying agent is supplied to the wafer 200 inside the process chamber 201, i.e., to the wafer 200 on which the new first film is formed inside the recess in step C. In this step, the modifying agent may be supplied to the wafer 200 according to the same processing procedure and processing condition as the modifying agent supply in step a2. The modifying agent used in this step may be referred to particularly as a second modifying agent.

By supplying the modifying agent to the wafer 200 under the above-described processing condition, a sixth layer may be formed by adsorbing at least a portion of a molecular structure of molecules constituting the modifying agent on the surface of the first film. Specifically, the OH termination formed on the surface of the first film may react with the modifying agent so that at least a portion of the molecular structure of the molecules constituting the modifying agent may be adsorbed on the surface of the first film. Thus, it becomes possible to terminate the surface of the first film with at least a portion of the molecular structure of the molecules constituting the modifying agent (first termination formation; *see* FIG. 7F). Examples and characteristics of the first termination are as described in step a2.

Further, as the modifying agent (second modifying agent) supplied to the wafer 200 in this step, a gas containing one or more of the gases exemplified as the modifying agent (first modifying agent) supplied to the wafer 200 in step a2 may be used. The second modifying agent may be the same as or different from the first modifying agent. In a case where a modifying agent different from the first modifying agent is used as the second modifying agent, a second modifying agent supply system configured to supply the second modifying agent is further installed. The second modifying agent supply system is configured, similarly to the above-described modifying agent supply system, with, for example, a gas supply pipe connected to the nozzle 249c, an MFC, and a valve.

After forming the first termination in the first region and the second region of the wafer 200, the valve 243c is closed to stop the supply of the modifying agent into the process chamber 201. Then, gaseous substances and others remaining inside the process chamber 201 are removed from the interior of the process chamber 201 according to the same processing procedure and processing condition as those of purging in step a1a.

[Execution for Predetermined Number of Times]

By performing a cycle in which the above-described steps B, E, C and D are performed in this order non-simultaneously, i.e., without synchronization, $n_1$ times (where, $n_1$ is an integer of 1 or 2 or more), the first film may be grown bottom-up from the bottom side toward the opening side of the recess, and the recess may be filled with the first film *(see* FIGS. 7C to 7J). Specifically, by performing, a predetermined number of times, a cycle including step C of forming the first film in the first region and the second region and step B of selectively removing the first film formed in the first region with respect to the first film formed in the second region, the first film may be grown bottom-up from a bottom side toward an opening side of an inner surface of the recess. The above-described cycle is desirably repeated multiple times until the recess is filled with the first film.

In addition, in each cycle including the above-described steps B, E, C and D, ranges of the first region and the second region may differ from cycle to cycle. For example, a supply (exposure) condition of the processing liquid in step B may be set such that the first region in a $k^{th}$ cycle (i.e., a region in which the first film to be exposed to the processing liquid in step B of the $k^{th}$ cycle is formed) becomes narrower in its range from the opening of the recess, than the first region in a $(k-1)^{th}$ cycle (i.e., a region in which the first film to be exposed to the processing liquid in step B of the $(k-1)^{th}$ cycle is formed). Further, for example, the supply condition of the processing liquid in step B may be set such that the first region in the $k^{th}$ cycle becomes the same as the first region in the $(k-1)^{th}$ cycle.

Further, when performing the above-described cycle, as the bottom-up film formation proceeds, it is desirable, in step B, to perform regulations such as gradually shortening the supply (exposure) time of the processing liquid to the wafer 200, so as to reduce the range of the surface of the first film exposed to the processing liquid. In this way, a void-free and continuous first film may be formed inside the recess, thereby improving filling characteristics.

Thereafter, after-purge, atmospheric pressure recovery, boat unloading, and wafer discharge are sequentially performed. Details are the same as those performed after step a2.

(3) Effects of Present Embodiment

According to the present embodiment, one or a plurality of effects described below are obtained.

(a) In step A, by preparing the wafer 200 in which the surface of the first film is terminated with the first termination that reduces the wettability with respect to the processing liquid, it is possible to make it difficult for the processing liquid to penetrate the interior of the recess (particularly the second region) in step B. Specifically, in step B, for example, even in a case where the wafer 200 with a structure in which the width w of the opening is relatively large, in other words, in which the processing liquid may relatively easily penetrate the interior of the recess (particularly the second region), is used, the first termination may make it difficult for the processing liquid to penetrate the interior of the recess. Thus, in step B, it is possible to expose the surface of the first film formed in the first region to the processing liquid selectively with respect to the surface of the first film formed in the second region. As a result, at least a portion of the first film formed in the first region may be removed, with the first film formed in the second region left remaining. In this way, the first film formed in the first region may be selectively removed.

(b) In step B, the range of the surface of the first film exposed to the processing liquid is controlled by regulating the supply time of the processing liquid to the wafer 200. Thus, the first film formed in the first region may be reliably removed selectively with respect to the first film formed in the second region. Further, in accordance with the bottom-up growth of the first film, the first film formed in a desired region among the first film formed in the first region may be selectively removed. As a result, a void-free and continuous first film may be formed inside the recess.

(c) In step B, at least a portion of the first film facing the inner space of the recess, for example, the first film formed in the second region, is not exposed to the processing liquid. Thus, it is possible to reliably remove the first film formed in the first region selectively with respect to the first film formed in the second region.

(d) In step B, at least a portion of the first film facing the inner space of the recess, for example, the first film formed in the second region, is not removed. Thus, it is possible to reliably perform the bottom-up growth of the first film.

(e) The wettability possessed by the first termination is such that the processing liquid is unable to penetrate the interior of the recess with respect to the opening width of the recess at the execution start time of step B. Thus, in step B, although the processing liquid is able to reach the first region (the opening side of the recess), it is difficult for the processing liquid to reach (penetrate) the second region (the bottom side of the recess). Therefore, it is possible to remove the first film formed in the first region selectively with respect to the first film formed in the second region.

(f) In step a2, by supplying the gaseous modifying agent to the wafer 200, it is possible for the modifying agent to widely spread and reach the second region as well as the first region. Thus, the above effect may be reliably obtained.

(g) after step C, step D is executed by supplying the modifying agent to the wafer 200 on which the first film is formed inside the recess, thereby modifying the surface of the first film into the surface containing the first termination. Thus, in step B of the next cycle, it is possible to reliably remove the first film formed in the first region selectively with respect to the first film formed in the second region.

(h) By executing a cycle including steps B, C and D multiple times, it is possible to reliably perform the bottom-up film formation, thereby enabling gap filling without voids or seams.

(i) After step B, step E is executed to remove at least a portion of the first termination from the surface of the first film. Thus, since the first termination acting as an inhibitor for the precursor is removed, it is possible to reliably form the first film in the second region as well as the first region in step C.

(4) Modifications

The substrate processing sequence in the present embodiment may be modified as in modifications described below. These modifications may be combined arbitrarily. Unless otherwise specified, the processing procedure and processing condition in each step of each modification may be the same as the processing procedure and processing condition in each step of the above-described processing sequence.

(Modification 1)

In the above-described embodiment, the example is described in which, in step A (specifically, step a1) and in step C, the first film (SiO film) containing the adsorption site (OH termination), to which at least a portion of the molecular structure of the modifying agent (hereinafter, also simply referred to as the modifying agent) is adsorbed, is formed on the wafer 200. Then, the example is described in which, in step A (specifically step a2) and in step D, the modifying agent is adsorbed to the adsorption site. However, for example, in step A (specifically, step a1) and in step C, a first film (e.g., a SiN film) containing no adsorption site (OH termination) to which the modifying agent is adsorbed may be formed on the wafer 200. Then, in this case, in step A (specifically, step a2) and in step D, an oxide layer containing an adsorption site (OH termination) of the modifying agent may be formed on the surface of the first film, and the first termination may be formed on the surface of the first film via the oxide layer. This modification is described mainly with reference to FIGS. 8A to 8C. In addition, FIGS. 8A to 8C are partial schematic diagrams of the wafer 200 when step A in this modification is executed, and partial schematic diagrams of the wafer 200 when steps B, E, C and D are executed are omitted.

Based on the above, in this modification, steps A, C and D may be changed as in the processing sequence illustrated below.

(Precursor → Second reactant) × $m_3$ → Oxide layer formation → Modifying agent → [Processing liquid → Heat treatment → (Precursor → Second reactant) × $m_4$ → Oxide layer formation → Modifying agent] × $n_2$

Specifically, in step A in this modification, a cycle including step a1a of supplying the precursor to the wafer 200 and step a1b of supplying the second reactant is performed a predetermined number of times ($m_3$ times, where $m_3$ is an integer of 1 or 2 or more) in step a1, thereby forming a first film (e.g., a SiN film) on the wafer 200 (see FIG. 8A). Thereafter, an oxide layer formation step of forming an oxide layer on the first film is performed (see FIG. 8B). Thereafter, in step a2, a first termination is formed on a surface of the first film by supplying the modifying agent to the wafer 200 on which the oxide layer is formed (see FIG. 8C).

Further, in steps C and D in this modification, a cycle including step c1 of supplying the precursor to the wafer 200 and step c2 of supplying the second reactant is performed a predetermined number of times ($m_4$ times, where $m_4$ is an integer of 1 or 2 or more) in step C, thereby forming a first film on the wafer 200. Thereafter, an oxide layer formation step of forming an oxide layer on the first film is performed. Thereafter, in step D, a first termination is formed on a surface of the first film by supplying the modifying agent to the wafer 200 on which the oxide layer is formed.

The processing procedure and processing condition of step A in this modification may be the same as the processing procedure and processing condition of step A in the above-described embodiment, except that the substance supplied in step a1b is the second reactant and that the oxide layer formation step of forming an oxide layer on the first film is performed after execution of step a1 and before execution of step a2.

The processing procedure and processing condition of steps C and D in this modification may be the same as the processing procedure and processing condition of steps C and D in the above-described embodiment, except that the substance supplied in step c2 is the second reactant and that the oxide layer formation step of forming an oxide layer on the first film is performed after execution of step C and before execution of step D.

In addition, the precursor used in steps A and C in this modification may be a substance with the same molecular structure as that of the precursor used in steps A and C in the above-described embodiment. In addition, the modifying agent used in steps A and D of this modification may be a substance with the same molecular structure as that of the modifying agent used in steps A and D in the above-described embodiment.

In a case where, for example, a nitriding gas (nitriding agent) such as a nitrogen (N) and hydrogen (H) containing gas is used as the second reactant, a SiN film, for example, may be formed on the wafer 200 in steps A and C. In this way, for example, a first film including a surface formed with a NH termination may be formed in the first region and the second region *(see* FIG. 8A).

As the second reactant, for example, the above-described N- and H-containing substance may be used. For example, a nitrogen hydride-based substance such as ammonia ($NH_3$), diazene ($N_2H_2$), hydrazine ($N_2H_4$), $N_3H_8$, or the like may be used as the N- and H-containing substance. One or more of these may be used as the second reactant.

Further, in steps A and C in this modification, for example, since a SiN film is formed as the first film, it is desirable that the processing liquid supplied to the wafer 200 in step B in this modification be, for example, a hot phosphoric acid aqueous solution or the like.

In this modification as well, the same effects as those in the above-described embodiment are obtained. In this modification, even in a case where the first film including no adsorption site for adsorbing the modifying agent is formed on the wafer 200, the oxide layer (including an adsorption site of the modifying agent) may be formed on the surface of the first film, thereby indirectly allowing the surface of the first film to be terminated with the first termination. Thus, it is possible to reduce the wettability of the surface of the first film with respect to the processing liquid.

Further, mainly two methods may be mentioned as the method of forming the oxide layer in the above-described oxide layer formation step. Details of these methods are described in Modification 1-1 and Modification 1-2 described below.

[Modification 1-1: Oxide Layer Formation Step]

In the oxide layer formation step in this modification, an oxide layer containing a predetermined element may be formed on the first film by supplying an O-containing gas and a precursor containing the predetermined element to the wafer 200 *(see* FIG. 8B). Specifically, an oxide layer may be formed on the first film by performing a cycle, including a step of supplying a precursor to the wafer 200 and a step of supplying a first reactant to the wafer 200, a predetermined number of times ($p_1$ times, where $p_1$ is an integer of 1 or 2 or more).

The oxide layer formation step in this modification may be performed according to the same processing procedure and processing condition as those of step A (specifically, steps a1a and a1b) in the above-described embodiment. The precursor and the first reactant used in the oxide layer formation step in this modification may be substances with the same molecular structures as those of the precursor and the first reactant used in steps a1a and a1b in the above-described embodiment.

[Modification 1-2: Oxide Layer Formation Step]

In the oxide layer formation step in this modification, an oxidizing agent may be supplied to the wafer 200 on which the first film is formed, thereby oxidizing the surface of the first film *(see* FIG. 8B). Specifically, an oxide layer may be formed on the surface of the first film by supplying, to the wafer 200, an activated first reactant, i.e., a first reactant excited into a plasma state (plasma oxidation).

In addition, the first reactant may be excited into a plasma state by using the above-described RPU 270. Specifically, the valve 243b is opened, and the first reactant is flowed into the gas supply pipe 232b. The first reactant is regulated in flow rate by the MFC 241b, is excited into a plasma state by the RPU 270, is supplied into the process chamber 201 through the nozzle 249b, and is exhausted from the exhaust port 231a. At this time, the first reactant is supplied to the wafer 200.

The first reactant used in the oxide layer formation step in this modification may be a substance with the same molecular structure as that of the first reactant used in step a1b in the above-described embodiment.

(Modification 2)

In the above-described embodiment, the example is described in which, in steps A and C, an SiO film is formed as the first film on the wafer 200 and the first film is terminated with a H termination serving as the first termination. However, for example, in steps A and C, a carbon (C)-containing film may be formed as a first film on the wafer 200, and a C-termination serving as a first termination may be formed on a surface of the first film. This modification is described mainly with reference to FIGS. 9A and 9B. In addition, FIGS. 9A and 9B are partial schematic diagrams of the wafer 200 when steps A and B in this modification are executed, and partial schematic diagrams of the wafer 200 when steps E, C and D are executed are omitted.

Based on the above, in this modification, steps A, C and D may be changed as in the processing sequence illustrated below.

(Precursor → Third reactant → First reactant) $\times$ $m_5$ → [Processing liquid → Heat treatment → (Precursor → Third reactant → First reactant) $\times$ $m_6$] $\times$ $n_3$

Specifically, in step A in this modification, a cycle including step a1a of supplying a precursor to the wafer 200, a step of supplying a third reactant, and step a1b of supplying a first reactant is performed a predetermined number of times ($m_5$ times, where $m_5$ is an integer of 1 or 2 or more) in step a1, thereby forming a first film on the wafer 200. In step A in this modification, step a2 performed in the above-described embodiment may be omitted.

In step C in this modification, a cycle including step c1 of supplying a precursor to the wafer 200, a step of supplying a third reactant, and step c2 of supplying a first reactant is performed a predetermined number of times ($m_6$ times, where $m_6$ is an integer of 1 or 2 or more), thereby forming a first film on the wafer 200. In this modification, step D, which is performed after execution of step C in the above-described embodiment, may be omitted.

The processing procedure and processing condition of step A in this modification may be the same as the processing procedure and processing condition of step A in the above-described embodiment, except that in step a1, the third reactant is supplied to the wafer 200 in addition to the precursor and the first reactant, and that step a2 is not performed.

The processing procedure and processing condition of step C in this modification may be the same as the processing procedure and processing condition of step C in the above-described embodiment, except that the third reactant is supplied to the wafer 200 in addition to the precursor and the first reactant.

In addition, the precursor and the first reactant used in steps A and C of this modification may be substances with the same molecular structure as those of the precursor and the first reactant used in steps A and C in the above-described embodiment.

As the procedure of supplying the third reactant to the wafer 200, the valve 243c is opened, and the third reactant is flowed into the gas supply pipe 232c. The third reactant is regulated in flow rate by the MFC 241c, is supplied into the process chamber 201 through the nozzle 249c, and is exhausted from the exhaust port 231a. At this time, the third reactant is supplied to the wafer 200.

By supplying the third reactant to the wafer 200 under the above-described processing condition, at least a portion of a layer containing, for example, Si and O, which is formed on the wafer 200 by supplying the precursor and the first reactant, may be modified. For example, in a case where a C-containing substance is used as the third reactant, a layer containing, for example, Si and O, on the wafer 200 is carbonized, and a SiOC layer containing a C group (carbon group) termination (C termination) is formed.

As the third reactant, for example, the above-described C-containing substance may be used. Examples of the C-containing substance may include ethylene ($C_2H_4$), acetylene ($C_2H_2$), propylene ($C_3H_6$), and the like. One or more of these may be used as the third reactant.

By performing a cycle in which the above-described steps of supplying the precursor, third reactant, and first reactant respectively are performed in this order non-simultaneously, i.e., without synchronization, $m_6$ times (where, $m_6$ is an integer of 1 or 2 or more), a first film may be formed on the wafer 200. For example, in a case where the above-described precursor, first reactant, and third reactant are used, a SiOC film, for example, may be formed as the first film on the wafer 200. Since a surface of the SiOC film is terminated with a C termination serving as the first termination, when the first film is formed on the wafer 200, the C termination serving as the first termination, which reduces wettability with respect to the processing liquid, is formed on a surface of the first film at the same time *(see* FIG. 9A).

In this modification as well, the same effects as those in the above-described embodiment are obtained. Further, in this modification, after formation of the first film, step B (removal process) may be performed without performing the step of modifying the surface of the first film into a surface containing the first termination *(see* FIGS. 9A and 9B).

<Other Embodiments of Present Disclosure>

The embodiments of the present disclosure are specifically described above. However, the present disclosure is not limited to the above-described embodiments, and may be changed in various ways without departing from the gist of the present disclosure.

For example, as the modifying agent used in the modification process (step a2, step D), a substance in which an amino group and an alkyl group are bonded to Si such as (dimethylamino)trimethylsilane ($(CH_3)_2NSi(CH_3)_3$), (diethylamino)triethylsilane ($(C_2H_5)_2NSi(C_2H_5)_3$), (dimethylamino)triethylsilane ($(CH_3)_2NSi(C_2H_5)_3$), (diethylamino)trimethylsilane ($(C_2H_5)_2NSi(CH_3)_3$), (diisopropylamino)trimethylsilane ($(C_3H_7)_2NSi(CH_3)_3$), or the like, i.e., an alkylaminosilane, may be used. In this case, an alkyl termination is formed as the first termination on the surface of the first film. In this embodiment as well, the same effects as those in the above-described embodiments are obtained.

In general, compared with a case where a H termination or an alkoxy group termination is formed as the first termination, formation of an alkyl termination may more strongly reduce the wettability of the wafer 200 with respect to the processing liquid (i.e., may increase the hydrophobicity of the surface of the wafer 200). Thus, for example, in a case where an alkyl termination is formed as the first termination, the processing time in the removal process (step B) is longer than in a case where a H termination or an alkoxy group termination is formed, but at the same time, a stable removal with a high controllability may be performed. It is desirable to select a modifying agent to be used in consideration of these points.

In the above-described embodiments, the example is described in which the supply time of the processing liquid to the wafer 200 is regulated as a method of controlling the range of the surface of the first film exposed to the processing liquid in step B. However, for example, a modifying agent to be used may be selected in consideration of a magnitude of hydrophobicity possessed by the modifying agent. Further, a density of a termination (e.g., OH termination) on the surface of the wafer 200 as an adsorption site of the modifying agent may be regulated by supplying an oxidizing agent or others to the wafer 200 before supplying the modifying agent. At this time, as a mode of supplying the oxidizing agent, the wafer 200 may be exposed to the atmosphere. In this embodiment as well, the same effects as those in the above-described embodiments are obtained.

In the above-described embodiments, the example is described in which the wafer 200 is subjected to heat treatment (annealing) as a method of desorbing the first termination from the surface of the wafer 200 before execution of the film formation process (step C). However, for example, an oxidizing agent or a liquid containing an OH bond, such as alcohol water, which exhibits a lower surface tension than the processing liquid, may be supplied to the wafer 200. Further, in a case where step C is performed under a high temperature condition, the first termination may desorb from the surface of the wafer 200 during execution of step C, and therefore, a pre-treatment may not be needed. In this embodiment as well, the same effects as those in the above-described embodiments are obtained.

In the above-described embodiments, the example is described in which the same modifying agent is used in step D (modification process) in each cycle. However, for example, a magnitude of hydrophobicity possessed by the first termination may differ from cycle to cycle, such as by using an aminosilane in the first cycle and an alkylaminosilane in the second cycle. Further, in the above-described embodiments, the example is described in which the same processing liquid is used in step B (removal process) from cycle to cycle. However, for example, a magnitude of surface tension of the processing liquid may differ from cycle to cycle, such as by using a HF aqueous solution in the first cycle and a HF aqueous solution with an added alcohol in the second cycle. In this way, the range of the surface of the first film exposed to the processing liquid and the processing time may be controlled.

In the above-described embodiments, the example is described in which the predetermined element contained in the precursor is Si. However, for example, the predetermined element may also be a metal element such as titanium (Ti), zirconium (Zr), hafnium (Hf), tantalum (Ta), niobium (Nb), aluminum (Al), molybdenum (Mo), tungsten (W), germanium (Ge), or the like. In such a case, as the first film, for example, an oxide film containing such a metal element or a nitride film containing such a metal element is formed. In this embodiment as well, the same effects as those in the above-described embodiments are obtained.

In addition, it is desirable that the processing liquid used in step B be selected depending on a type of the first film. In a case where the first film is, for example, an aluminum oxide film, a hafnium oxide film, or a titanium oxide film, it is desirable to use a HF aqueous solution as the processing liquid in any case. In a case where the first film is, for example, a titanium nitride film, it is desirable to use, as the processing liquid, a mixed solution of aqueous ammonia, aqueous hydrogen peroxide, and pure water. In this embodiment as well, the same effects as those in the above-described embodiments are obtained.

Although not specifically described in the above-described embodiments, the effects of the above-described embodiments may be significantly obtained in a case where the wafer 200 possesses an opening width w of the recess such that the processing liquid becomes difficult to penetrate the interior of the recess due to the formation of the first termination on the surface of the first film. Specifically, for example, in a case where the opening width w of the recess at the execution start time of step B is of such a size that the processing liquid is unable to penetrate the interior of the recess due to the surface tension of the processing liquid, or that the processing liquid is able to penetrate the interior of the recess when the first termination is absent on the surface of the first film, the effects of the above-described embodiments may be significantly obtained.

The present disclosure is not limited to the above-described embodiments, and for example, may also be suitably applied to a case where a film is formed using a single-wafer-type substrate processing apparatus 100 that processes one or several substrates at a time. Further, the present disclosure is not limited to the above-described embodiments, and may also be suitably applied to a case where a film is formed using a substrate processing apparatus 100 including a cold-wall-type process furnace. Even in a case where such a substrate processing apparatus 100 is used, each process may be performed under the same processing procedures and processing conditions as those in the above-described embodiments and modifications, and the same effects as those in the above-described embodiments and modifications may be obtained.

The above-described embodiments and modifications may be used in combination as appropriate. The processing procedure and processing condition at this time may be the same as the processing procedures and processing conditions in the above-described embodiments and modifications, for example.

According to the present disclosure, it is possible to selectively remove a film formed inside a recess by using a processing liquid.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. A method of processing a substrate (200), comprising:

   (a) preparing the substrate (200) including a first film formed inside a recess, a surface of the first film inside the recess being terminated with a first termination that reduces wettability with respect to a processing liquid; and
   (b) removing at least a portion of the first film formed in a first region on an opening side of the recess while leaving the first film formed in a second region on a bottom side of the recess by supplying the processing liquid to the substrate (200) and selectively exposing, to the processing liquid, the surface of the first film formed in the first region with respect to the surface of the first film formed in the second region.

2. The method of Claim 1, wherein the first termination is formed on the surface of the first film by supplying a modifying agent to the substrate (200) on which the first film is formed inside the recess.

3. The method of Claim 1 or 2, wherein the first termination is formed by at least a portion of a molecular structure of a modifying agent being adsorbed to an adsorption site of an oxide layer that is formed on the surface of the first film before the first termination is formed.

4. The method of any one of Claims 1 to 3, wherein in (b), a range of the surface of the first film exposed to the processing liquid is controlled by regulating a supply time of the processing liquid to the substrate (200).

5. The method of any one of Claims 1 to 4, wherein the first film formed inside the recess of the substrate (200) prepared in (a) includes an inner space of the recess that is in communication with an outer space of the recess, and wherein in (b), at least a portion of the first film facing the inner space is not exposed to the processing liquid.

6. The method of any one of Claims 1 to 5, wherein an opening width of the recess at an execution start time of (b) is a width at which the processing liquid is unable to come into contact with an inner sidewall surface of the recess.

7. The method of any one of Claims 1 to 6, wherein an opening width of the recess at an execution start time of (b) is a width at which the processing liquid is able to penetrate an interior of the recess when the first termination is absent on the surface of the first film.

8. The method of Claim 7, wherein a degree of the wettability is such that, at the execution start time of (b), the processing liquid is unable to come into contact with an inner sidewall surface of the recess.

9. The method of any one of Claims 1 to 8, further comprising:

(c) after (b), forming the first film inside the recess from which the first film formed in the first region is removed.

10. The method of Claim 9, further comprising:
(d) after (c), modifying the surface of the first film into a surface containing the first termination by supplying a modifying agent to the substrate (200) on which the first film is formed inside the recess.

11. The method of Claim 10, wherein a cycle including (b), (c) and (d) is executed a plurality of times.

12. A method of manufacturing a semiconductor device, comprising the method of Claim 1.

13. A program that causes, by a computer, a substrate processing apparatus (100) to perform a process comprising:

(a) preparing a substrate (200) including a first film formed inside a recess, a surface of the first film inside the recess being terminated with a first termination that reduces wettability with respect to a processing liquid; and
(b) removing at least a portion of the first film formed in a first region on an opening side of the recess while leaving the first film formed in a second region on a bottom side of the recess by supplying the processing liquid to the substrate (200) and selectively exposing, to the processing liquid, the surface of the first film formed in the first region with respect to the surface of the first film formed in the second region.

14. A substrate processing apparatus (100) comprising:

a processing liquid supply system configured to supply a processing liquid to a substrate (200); and
a controller (121) configured to be capable of controlling the processing liquid supply system, so as to perform, on the substrate (200) including a first film formed inside a recess and where a surface of the first film inside the recess is terminated with a first termination that reduces wettability with respect to the processing liquid, a process of removing at least a portion of the first film formed in a first region on an opening side of the recess while leaving the first film formed in a second region on a bottom side of the recess by supplying the processing liquid to the substrate (200) and selectively exposing, to the processing liquid, the surface of the first film formed in the first region with respect to the surface of the first film formed in the second region.

15. The substrate processing apparatus (100) of Claim 14, further comprising:

a modifying agent supply system configured to supply a modifying agent to the substrate (200),
wherein the controller (121) is configured to be capable of controlling the modifying agent supply system, so as to perform a process of modifying the surface of the first film into a surface containing the first termination by supplying the modifying agent to the substrate (200) on which the first film is formed inside the recess.

FIG. 1

# FIG. 2

# FIG. 3

# FIG. 4

# FIG. 5

FIG. 6

First region

Second region

200

## FIG. 7A

OH          OH

First film

OH   HO

OH   HO

OH   HO

OH   HO

OH   HO

200

## FIG. 7B

H (First termination)   H

First film

H     H

H     H

H     H

H     H

H     H

200

## FIG. 7C

(First termination)

H  H

H  H

H  H

First film

200

## FIG. 7D

First film

200

## FIG. 7E

## FIG. 7F

# FIG. 7G

(First termination)

H

H

H

H

First film

First film

200

# FIG. 7H

First film

First film

200

# FIG. 7I

OH    OH ────First film

OH

HO─

OH

First film

First film

200

# FIG. 7J

H    H ────First film

H─

H─

H

First film
First film

200

# FIG. 8A

# FIG. 8B

# FIG. 8C

H (First termination) H

200

## FIG. 9A

C (First termination) C

First film

C C

C C

C C

C C

C C

200

## FIG. 9B

(First termination)

C C

C C

C C

200

Europäisches
Patentamt
European
Patent Office
Office européen
des brevets

# EUROPEAN SEARCH REPORT

**Application Number**

EP 26 15 4827

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/243734 A1 (ISHIKAWA DAI [JP] ET AL) 24 August 2017 (2017-08-24) | 1,2,4,9, 11-15 | INV. H10P14/60 |
| Y | * paragraph [0033] * | 3,5-8,10 | H10P14/692 |
| | * paragraph [0038] - paragraph [0041] * | | H10P14/694 |
| | * paragraph [0002] * | | H10P50/68 |
| | * figure 14 * | | H10P95/70 |
| | ----- | | |
| Y | US 2023/369031 A1 (KITAJIMA TOMOHIKO [US] ET AL) 16 November 2023 (2023-11-16) * paragraph [0040] * * figure 3B * | 3,10 | |
| | ----- | | |
| Y | US 6 872 621 B1 (WU YUNG-HSIEN [TW]) 29 March 2005 (2005-03-29) * figures 1D-1F * | 5-8 | |
| | ----- | | |

**TECHNICAL FIELDS
SEARCHED (IPC)**

H10P

The present search report has been drawn up for all claims

| Place of search | Date of completion of the search | Examiner |
|---|---|---|
| The Hague | 26 May 2026 | Boubal, François |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

................................................................................

& : member of the same patent family, corresponding
   document

EPO FORM 1503 03.82 (P4C01)

## ANNEX TO THE EUROPEAN SEARCH REPORT
## ON EUROPEAN PATENT APPLICATION NO.

EP 26 15 4827

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2026

| Patent document cited in search report | | | Publication date | Patent family member(s) | | Publication date |
|---|---|---|---|---|---|---|
| US 2017243734 | A1 | | 24-08-2017 | CN 107104036 | A | 29-08-2017 |
| | | | | JP 6920068 | B2 | 18-08-2021 |
| | | | | JP 2017147444 | A | 24-08-2017 |
| | | | | KR 20170098189 | A | 29-08-2017 |
| | | | | TW 201740462 | A | 16-11-2017 |
| | | | | US 2017243734 | A1 | 24-08-2017 |
| US 2023369031 | A1 | | 16-11-2023 | CN 117501824 | A | 02-02-2024 |
| | | | | EP 4321006 | A1 | 14-02-2024 |
| | | | | JP 7653542 | B2 | 28-03-2025 |
| | | | | JP 2024527223 | A | 24-07-2024 |
| | | | | JP 2025118588 | A | 13-08-2025 |
| | | | | KR 20230159294 | A | 21-11-2023 |
| | | | | KR 20240005938 | A | 12-01-2024 |
| | | | | TW 202409321 | A | 01-03-2024 |
| | | | | TW 202546897 | A | 01-12-2025 |
| | | | | US 2023369031 | A1 | 16-11-2023 |
| | | | | US 2023420232 | A1 | 28-12-2023 |
| | | | | WO 2023219732 | A1 | 16-11-2023 |
| US 6872621 | B1 | | 29-03-2005 | TW I227541 | B | 01-02-2005 |
| | | | | US 6872621 | B1 | 29-03-2005 |

EPO FORM P0459

For more details about this annex : see Official Journal of the European Patent Office, No. 12/82

**EP 4 788 111 A1**

**REFERENCES CITED IN THE DESCRIPTION**

**Patent documents cited in the description**

• JP 2025015076 A